# EUROPEAN PATENT APPLICATION

(11) **EP 4 542 625 A1**
(43) Date of publication of application: **23.04.2025**
(21) Application number: 23823859.6
(22) Date of filing: 09.06.2023
(51) Int. Cl.: H01L 21/302

(54) **ETCHING METHOD, METHOD FOR PRODUCING SEMICONDUCTOR DEVICE, ETCHING APPARATUS AND ETCHING GAS**

(30) Priority: 16.06.2022 JP 2022097286
(71) Applicant: Central Glass Company, Limited, Ube-shi, Yamaguchi 755-0001 (JP)
(72) Inventor: FUKUI, Yuki, Tokyo 101-0054 (JP); OOMORI, Hiroyuki, Tokyo 101-0054 (JP); KIKUCHI, Akiou, Tokyo 101-0054 (JP)
(74) Representative: Manitz Finsterwald Patent- und Rechtsanwaltspartnerschaft mbB
(86) International application number: PCT/JP2023/021595
(87) International publication number: WO 2023/243569

(57) **Abstract**

The present disclosure aims to provide a technology capable of etching a film at least containing Si and N in a substrate having a film at least containing Si and O and the film at least containing Si and N while suppressing etching of the film at least containing Si and O. The present disclosure relates to an etching method including bringing (I) HF gas and (II) at least one compound selected from the group consisting of a sulfonyl compound, a carbonyl compound, a sulfonyl isocyanate compound, and an isocyanate compound into contact with a substrate having a film at least containing Si and O and a film at least containing Si and N to etch the film at least containing Si and N.

## Description

### TECHNICAL FIELD

The present disclosure relates to an etching method using HF gas and at least one compound selected from the group consisting of a sulfonyl compound, a carbonyl compound, a sulfonyl isocyanate compound, and an isocyanate compound, a method of producing a semiconductor device, an etching device, and an etching gas.

### BACKGROUND ART

The production of a semiconductor device may include selective etching of silicon nitride (SiN) from a structure where SiN is adjacent to silicon oxide (SiO₂) on a single-crystal silicon substrate.

Known methods for etching SiN include wet etching using thermal phosphoric acid and dry etching using plasma generated from a gaseous compound such as CF₄ or other halocarbons.

For example, Patent Literature 1 describes a dry etching method that uses an etching gas containing a gaseous compound represented by the formula: CHₓF₄₋ₓ wherein x represents 2 or 3, gaseous oxygen, etc. to selectively plasma etch SiN in the presence of SiO₂, a metal silicide, or silicon. As described in Patent Literature 1, a SiN film is selectively etched through an opening of a SiO₂ film, and the underlying p-Si film is used as an etch stop layer.

However, wet etching using thermal phosphoric acid or dry etching using plasma can etch not only SiN but also SiO₂, raising concerns about the difficulty in increasing the selection ratio of SiN to SiO₂.

Then, Patent Literature 2 describes a method of etching a SiN film formed on a SiO₂ film by flowing HF gas in a heated non-plasma environment. In the method of Patent Literature 2, however, when the SiN film is etched with HF gas, the SiO₂ film may be etched with HF and the reaction product NH₃. Thus, it may not be possible to increase the SiN/SiO₂ selection ratio.

Then, Patent Literature 3 describes a method of etching a SiN film at a high selection ratio relative to a SiO₂ film using a gas mixture of HF and a fluorinated carboxylic acid. As described, the fluorinated carboxylic acid has the feature of trapping NH₃ generated as a by-product of the etching of the SiN film with HF to prevent the etching of the SiO₂ film, while not inhibiting the etching of SiN with HF.

### CITATION LIST

### - Patent Literature

Patent Literature 1: JP H8-59215 A
Patent Literature 2: JP 2008-187105 A
Patent Literature 3: JP 2019-91890 A

### SUMMARY OF INVENTION

### - Technical problem

The present disclosure aims to provide a technology capable of etching a film at least containing Si and N in a substrate having a film at least containing Si and O and the film at least containing Si and N while suppressing etching of the film at least containing Si and O.

### - Solution to problem

As a result of extensive studies, the present inventors have found that the above problem can be solved by etching a SiN film using a combination of HF with a sulfonyl compound, a carbonyl compound, a sulfonyl isocyanate compound, or an isocyanate compound which can bind to Si-NH₂ on the surface of the SiN film, thereby preventing the generation of NH₃, which would originally have been generated as a by-product of a reaction between HF and SiN.

The method of Patent Literature 3 suppresses the etching of the SiO₂ film by forming a salt between the fluorinated carboxylic acid and the by-product NH₃ to trap NH₃. In contrast, the sulfonyl compound, carbonyl compound, sulfonyl isocyanate compound, or isocyanate compound in the present disclosure can directly bind to Si-NH₂ on the surface of the SiN film without proton (H⁺) release, thereby suppressing the original generation of NH₃ itself. Thus, it is believed that the effect of suppressing the etching of the SiO₂ film is further improved.

Specifically, the present disclosure provides an etching method, a method of producing a semiconductor device, and an etching device according to any of the following (1) to (18).
(1) An etching method, including bringing (I) HF gas and (II) at least one compound selected from the group consisting of a sulfonyl compound represented by the following formula [1], a carbonyl compound represented by the following formula [2], a sulfonyl isocyanate compound represented by the following formula [3], and an isocyanate compound represented by the following formula [4] into contact with a substrate having a film at least containing Si and O and a film at least containing Si and N to etch the film at least containing Si and N,

   R¹-S(=O)₂-X [1]

   wherein R¹ represents a halogen atom or a linear or branched C1-C6 alkyl group in which some or all hydrogen atoms are optionally replaced by fluorine atoms, and X represents a halogen atom;

   R²-C(=O)-R³ [2]

   wherein R² and R³ each independently represent a hydrogen atom, a halogen atom, an isocyanate group, or a linear or branched C1-C6 alkyl group in which some or all hydrogen atoms are optionally replaced by fluorine atoms;

   R⁴-S(=O)₂N=C=O [3]

   wherein R⁴ represents a halogen atom or a linear or branched C1-C6 alkyl group in which some or all hydrogen atoms are optionally replaced by fluorine atoms; and

   R⁵-N=C=O [4]

   wherein R⁵ represents a linear or branched C1-C10 alkyl group in which some or all hydrogen atoms are optionally replaced by fluorine atoms.
(2) The etching method according to the above embodiment (1),
   wherein the film at least containing Si and N is etched without plasma.
(3) The etching method according to the above embodiment (1) or (2),
   wherein the film at least containing Si and N is selectively etched.
(4) The etching method according to the above embodiment (1) or (2),
   wherein the film at least containing Si and N is selectively etched, and
   the film at least containing Si and O is etched at a rate of 1.0 nm/min or less.
(5) The etching method according to any one of the above embodiments (1) to (4),
   wherein R¹ in formula [1] represents a fluoroalkyl group or a fluorine atom, and X represents a fluorine atom.
(6) The etching method according to any one of the above embodiments (1) to (5),
   wherein the sulfonyl compound represented by formula [1] is trifluoromethanesulfonyl fluoride (CF₃S(=O)₂F) or sulfuryl fluoride (SO₂F₂).
(7) The etching method according to any one of the above embodiments (1) to (6),
   wherein the carbonyl compound represented by formula [2] is hexafluoroacetone (CF₃C(=O)CF₃), trifluoroacetaldehyde (CF₃C(=O)H), or fluorocarbonyl isocyanate (FC(=O)N=C=O).
(8) The etching method according to any one of the above embodiments (1) to (7),
   wherein the isocyanate compound represented by formula [3] is fluorosulfonyl isocyanate (FS(=O)₂N=C=O).
(9) The etching method according to any one of the above embodiments (1) to (8),
   wherein the etching is performed with the substrate placed in a chamber, and
   the method includes subjecting an interior of the chamber to a reduced pressure condition.
(10) The etching method according to any one of the above embodiments (1) to (9),
   wherein the (I) HF gas and the (II) compound are simultaneously brought into contact with the substrate.
(11) The etching method according to any one of the above embodiments (1) to (9),
   wherein the method includes:
   a first etching step including bringing the (I) HF gas into contact with the substrate; and
   a second etching step including bringing the (II) compound into contact with the substrate.
(12) The etching method according to the above embodiment (11),
   wherein the etching is performed by repeating the first etching step and the second etching step.
(13) The etching method according to the above embodiment (11) or (12),
   wherein the second etching step is followed by the first etching step.
(14) The etching method according to any one of the above embodiments (1) to (13),
   wherein the film at least containing Si and O is a silicon oxide (SiO₂) film.
(15) The etching method according to any one of the above embodiments (1) to (14),
   wherein the film at least containing Si and N is a silicon nitride (SiN) film.
(16) The etching method according to any one of the above embodiments (1) to (13),
   wherein, in the substrate, the film at least containing Si and O and the film at least containing Si and N are a silicon oxide (SiO₂) film and a silicon nitride (SiN) film, respectively, and the silicon oxide film and the silicon nitride film are adjacent to each other and exposed.
(17) A method of producing a semiconductor device, the method including applying the etching method according to any one of the above embodiments (1) to (16) to a substrate having a silicon nitride film and a silicon oxide film to selectively etch the silicon nitride film.
(18) An etching device, including:
   a stage on which a substrate can be placed;
   a HF gas supply unit for supplying (I) HF gas; and
   a gaseous compound (II) supply unit for supplying gas of (II) at least one compound selected from the group consisting of a sulfonyl compound represented by the following formula [1], a carbonyl compound represented by the following formula [2], a sulfonyl isocyanate compound represented by the following formula [3], and an isocyanate compound represented by the following formula [4],

      R¹-S(=O)₂-X [1]

      wherein R¹ represents a halogen atom or a linear or branched C1-C6 alkyl group in which some or all hydrogen atoms are optionally replaced by fluorine atoms, and X represents a halogen atom;

      R²-C(=O)-R³ [2]

      wherein R² and R³ each independently represent a hydrogen atom, a halogen atom, an isocyanate group, or a linear or branched C1-C6 alkyl group in which some or all hydrogen atoms are optionally replaced by fluorine atoms;

      R⁴-S(=O)₂N=C=O [3]

      wherein R⁴ represents a halogen atom or a linear or branched C1-C6 alkyl group in which some or all hydrogen atoms are optionally replaced by fluorine atoms; and

      R⁵-N=C=O [4]

      wherein R⁵ represents a linear or branched C1-C10 alkyl group in which some or all hydrogen atoms are optionally replaced by fluorine atoms.
(19) An etching gas, containing:
   (I) HF gas; and
   (II) at least one compound selected from the group consisting of a sulfonyl compound represented by the following formula [1], a carbonyl compound represented by the following formula [2], a sulfonyl isocyanate compound represented by the following formula [3], and an isocyanate compound represented by the following formula [4],

      R¹-S(=O)₂-X [1]

      wherein R¹ represents a halogen atom or a linear or branched C1-C6 alkyl group in which some or all hydrogen atoms are optionally replaced by fluorine atoms, and X represents a halogen atom;

      R²-C(=O)-R³ [2]

      wherein R² and R³ each independently represent a hydrogen atom, a halogen atom, an isocyanate group, or a linear or branched C1-C6 alkyl group in which some or all hydrogen atoms are optionally replaced by fluorine atoms;

      R⁴-S(=O)₂N=C=O [3]

      wherein R⁴ represents a halogen atom or a linear or branched C1-C6 alkyl group in which some or all hydrogen atoms are optionally replaced by fluorine atoms; and

      R⁵-N=C=O [4]

      wherein R⁵ represents a linear or branched C1-C10 alkyl group in which some or all hydrogen atoms are optionally replaced by fluorine atoms.

### - Advantageous Effects of Invention

The present disclosure can have the effect of etching a film at least containing Si and N in a substrate having a film at least containing Si and O and the film at least containing Si and N while suppressing etching of the film at least containing Si and O by using an etching gas containing HF gas and at least one compound selected from the group consisting of a sulfonyl compound represented by formula [1], a carbonyl compound represented by formula [2], a sulfonyl isocyanate compound represented by formula [3], and an isocyanate compound represented by formula [4].

### BRIEF DESCRIPTION OF DRAWINGS

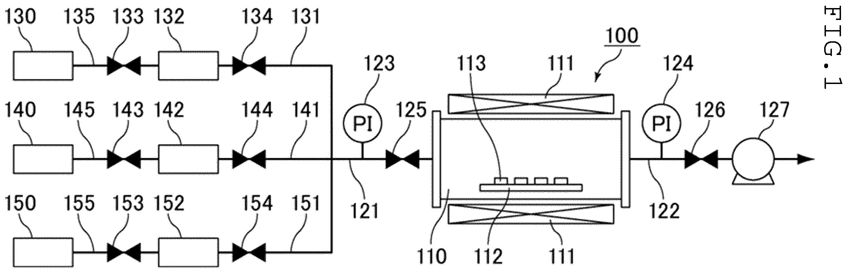

FIG. 1 shows a schematic diagram of an etching device according to an embodiment of the present disclosure.

### DESCRIPTION OF EMBODIMENTS

Hereinafter, embodiments of the present disclosure are described in detail. The present disclosure is not limited to the following embodiments and can be implemented as appropriate based on the common knowledge of those skilled in the art without impairing the gist of the present disclosure.

### <Etching method>

The etching method of the present disclosure includes bringing (I) HF gas and (II) at least one compound (hereinafter, also referred to as "(II) compound") selected from the group consisting of a sulfonyl compound represented by the following formula [1], a carbonyl compound represented by the following formula [2], a sulfonyl isocyanate compound represented by the following formula [3], and an isocyanate compound represented by the following formula [4] into contact with a substrate having a film at least containing Si and O and a film at least containing Si and N to etch the film at least containing Si and N,

R¹-S(=O)₂-X [1]

wherein R¹ represents a halogen atom or a linear or branched C1-C6 alkyl group in which some or all hydrogen atoms are optionally replaced by fluorine atoms, and X represents a halogen atom;

R²-C(=O)-R³ [2]

wherein R² and R³ each independently represent a hydrogen atom, a halogen atom, an isocyanate group, or a linear or branched C1-C6 alkyl group in which some or all hydrogen atoms are optionally replaced by fluorine atoms;

R⁴-S(=O)₂N=C=O [3]

wherein R⁴ represents a halogen atom or a linear or branched C1-C6 alkyl group in which some or all hydrogen atoms are optionally replaced by fluorine atoms; and

R⁵-N=C=O [4]

wherein R⁵ represents a linear or branched C1-C10 alkyl group in which some or all hydrogen atoms are optionally replaced by fluorine atoms.

The film at least containing Si and O may be a silicon oxide (SiO₂) film.

The film at least containing Si and N may be a silicon nitride (SiN) film.

Examples of the linear or branched C1-C6 alkyl group in which some or all hydrogen atoms are optionally replaced by fluorine atoms as R¹ in formula [1] include a methyl group, an ethyl group, an n-propyl group, an i-propyl group, an n-butyl group, a t-butyl group, an n-pentyl group, and a n-hexyl group. Examples of the halogen atom as R¹ in formula [1] include a fluorine atom, a chlorine atom, a bromine atom, and an iodine atom.

R¹ is preferably a fluoroalkyl group or a fluorine atom. R¹ is more preferably a trifluoromethyl group or a fluorine atom.

Examples of the halogen atom as X in formula [1] include those described for R¹. X is preferably a fluorine atom.

Specific examples of the sulfonyl compound represented by formula [1] include trifluoromethanesulfonyl fluoride (CF₃S(=O)₂F), sulfuryl fluoride (SO₂F₂), trifluoromethanesulfonyl chloride (CF₃S(=O)₂Cl), and sulfuryl chloride (SO₂Cl₂). The sulfonyl compound is preferably trifluoromethanesulfonyl fluoride (CF₃S(=O)₂F) or sulfuryl fluoride (SO₂F₂).

Examples of the halogen atom and the linear or branched C1-C6 alkyl group in which some or all hydrogen atoms are optionally replaced by fluorine atoms as R² and R³ in formula [2] include those described for R¹ in formula [1]. R² and R³ are each preferably an alkyl group, a trifluoroalkyl group, or a hydrogen atom, more preferably a methyl group, a trifluoromethyl group, or a hydrogen atom. A carbonyl compound in which one of R² and R³ is a halogen atom and the other is an isocyanate group is also preferred.

Specific examples of the carbonyl compound represented by formula [2] include hexafluoroacetone (CF₃C(=O)CF₃), trifluoroacetaldehyde (CF₃C(=O)H), acetone (CH₃C(=O)CH₃), acetaldehyde (CH₃C(=O)H), fluorocarbonyl isocyanate (FC(=O)N=C=O), and chlorocarbonyl isocyanate (ClC(=O)N=C=O) .

The carbonyl compound is preferably hexafluoroacetone (CF₃C(=O)CF₃), trifluoroacetaldehyde (CF₃C(=O)H), or fluorocarbonyl isocyanate (FC(=O)N=C=O), more preferably hexafluoroacetone (CF₃C(=O)CF₃) or trifluoroacetaldehyde (CF₃C(=O)H) .

Acetaldehyde and trifluoroacetaldehyde can exist as themselves or their stable equivalents, such as self-polymers, hydrates, hemiacetals, acetals, and compounds in which their structural features are combined. Therefore, in the present invention, these stable equivalents are also considered to be encompassed by the carbonyl compound represented by formula [2].

Examples of the halogen atom and the linear or branched C1-C6 alkyl group in which some or all hydrogen atoms are optionally replaced by fluorine atoms as R⁴ in formula [3] include those described for R¹ in formula [1]. R⁴ is preferably a halogen atom, more preferably a fluorine atom.

Specific examples of the sulfonyl isocyanate compound represented by formula [3] include fluorosulfonyl isocyanate (FS(=O)₂N=C=O) and chlorosulfonyl isocyanate (ClS(=O)₂N=C=O).

The sulfonyl isocyanate compound is preferably fluorosulfonyl isocyanate (FS(=O)₂N=C=O).

Examples of the linear or branched C1-C10 alkyl group in which some or all hydrogen atoms are optionally replaced by fluorine atoms as R⁵ in formula [4] include those described for R¹ in formula [1] as well as an n-heptyl group, an n-octyl group, an n-nonyl group, and an n-decyl group.

Specific examples of the isocyanate compound represented by formula [4] include methyl isocyanate, ethyl isocyanate, n-propyl isocyanate, isopropyl isocyanate, n-butyl isocyanate, and tert-butyl isocyanate.

In view of the reactivity with the film containing Si and N, the isocyanate compound is preferably methyl isocyanate, ethyl isocyanate, or n-propyl isocyanate.

The processing temperature at which the films formed on the substrate is brought into contact with the (I) HF gas is preferably 20°C or higher and 200°C or lower, more preferably 30°C or higher and 150°C or lower, still more preferably 40°C or higher and 130°C or lower. The processing temperature at which the films formed on the substrate is brought into contact with the (II) compound and the processing temperature at which the films formed on the substrate is brought into contact simultaneously with the (I) HF gas and the (II) compound are also preferably in the above temperature range. A processing temperature within the above temperature range leads to good reactivity with the film containing Si and N, high productivity, and small damage to the substrate.

The etching method of the present disclosure preferably includes etching the film at least containing Si and N without plasma. This is because, in the case where the substrate is a semiconductor device substrate, the substrate brought into contact with plasma gas may have electric damage due to the plasma gas.

The etching method of the present disclosure is suitable for selectively etching the film at least containing Si and N. Preferably, in the etching method of the present disclosure, the film at least containing Si and N is selectively etched, and the film at least containing Si and O is etched at a rate of 1.0 nm/min or less, more preferably 0.5 nm/min or less. The etching rate is calculated based on the HF gas contact time.

Herein, the phrase "selectively etching the film at least containing Si and N" means that the ratio of the etching rate of the film at least containing Si and N to the etching rate of the film at least containing Si and O (film containing Si and N/film containing Si and O) is 5 or higher. The etching rate ratio is preferably 10 or higher, more preferably 15 or higher, particularly preferably 30 or higher.

In the etching method of the present disclosure, the substrate is preferably a semiconductor device substrate such as a silicon substrate, a compound semiconductor substrate, a quartz substrate, or a glass substrate. In addition to the film at least containing Si and O and the film at least containing Si and N, a polycrystalline silicon film, a film containing a metal nitride, a silicon film, a metal wiring film, or other film may be formed on the surface of the substrate. An embodiment in which a silicon oxide film and a silicon nitride film are adjacent to each other and exposed is suitable for the etching method of the present disclosure. An embodiment in which a silicon nitride film is adjacent to a silicon oxide film and a polycrystalline silicon film, and the silicon oxide film, the polycrystalline silicon film, and the silicon nitride film are exposed is suitable for the etching method of the present disclosure.

For example, the substrate may be placed on a stage in an etching device, which will be described later, and the substrate as well as the film at least containing Si and O and the film at least containing Si and N formed on the surface of the substrate may be heated by heating the stage.

The films may be formed on the surface of the substrate by any method. Examples include chemical vapor deposition (CVD) and sputtering. Moreover, the film at least containing Si and O and the film at least containing Si and N may have any thickness. For example, the thickness may be 0.1 nm or more and 1 µm or less.

In the etching method of the present disclosure, the etching is preferably performed with the substrate placed in a chamber. The etching method of the present disclosure preferably includes subjecting the interior of the chamber to a reduced pressure condition. The etching method of the present disclosure more preferably includes bringing the (I) HF gas and the (II) compound into contact with the substrate having the film at least containing Si and O and the film at least containing Si and N in the chamber, followed by subjecting the interior of the chamber to a reduced pressure condition. This is because by-products generated during the etching can be removed.

The term "reduced pressure condition" means a condition where the pressure in the chamber is lower than the pressure (processing pressure) during the etching and is approximately 0.133 kPa or lower.

The etching method of the present disclosure preferably includes purging the interior of the chamber with inert gas. The etching method of the present disclosure more preferably includes bringing the (I) HF gas into contact with the (II) compound, followed by purging the interior of the chamber with inert gas. This is because by-products generated during the etching can be removed.

The etching method of the present disclosure may include subjecting the interior of the chamber to a reduced pressure condition, followed by purging the interior of the chamber with inert gas.

For example, an oxide film, an oxynitride film, or other similar film is usually formed on the surface of SiN, which is an exemplary film containing Si and N. Therefore, the etching method of the present disclosure may include removing such a film before bringing the (I) HF gas and the (II) compound into contact with the substrate.

### [First etching method]

First, a first etching method that includes simultaneously bringing the (I) HF gas and the (II) compound into contact with the substrate is described as an embodiment of the etching method of the present disclosure. Hereinafter, the etching gas used in the first etching method is referred to as etching gas A. The etching gas A at least contains the (I) HF gas and the (II) compound.

In the following description, the film at least containing Si and O and the film at least containing Si and N are also referred to as the film to be etched.

When the (I) HF gas and the (II) compound are simultaneously brought into contact with the heated film to be etched, it is believed that the (II) compound may directly bind to Si-NH₂ on the surface of the film containing Si and N (particularly, SiN film), thereby suppressing the NH₃ generation. Thus, it is considered that the etching of the film containing Si and O with NH₃ can be suppressed, and the film containing Si and N in the film to be etched can be selectively etched.

The (II) compound may be as described above.

The volume ratio of the (I) HF gas and the (II) compound is preferably HF gas:(II) compound = 10:at least 0.01 but not more than 10, more preferably 10:at least 0.01 but not more than 6. Too low a proportion of HF gas tends to lead to a reduction in etching rate. Too high a proportion of HF gas will excessively increase the cost. Too large an amount of (II) compound can also reduce the progress of etching.

Since even a trace amount of (II) compound can exhibit the effect, the amount of (II) compound may be at least 1 ppm by volume based on the combined amount of HF gas, (II) compound, and the additive gas described later, taken as 100 vol%.

Although the etching gas A may consist of the (I) HF gas and the (II) compound, it may further contain at least one additive gas selected from the group consisting of O₂, NO, N₂O, CO, CO₂, H₂O₂, and alcohols, or may further contain at least one inert gas selected from the group consisting of N₂, Ar, He, Ne, and Kr. Moreover, examples of usable alcohols include methanol, ethanol, propanol, and isopropyl alcohol.

When the additive gas is used, the total amount of additive gas may be 10 vol% or more and 90 vol% or less based on the combined amount of (I) HF gas, (II) compound, additive gas, and inert gas taken as 100 vol%.

When the etching gas A contains the inert gas, the amount of inert gas in the etching gas A is preferably 1 vol% or more and 90 vol% or less, more preferably 10 vol% or more and 80 vol% or less, still more preferably 30 vol% or more and 50 vol% or less based on to the combined amount of (I) HF gas, (II) compound, additive gas, and inert gas taken as 100 vol%.

The moisture content of the etching gas A is preferably less than 1% by mass, because with a high moisture content, H₂O can be generated upon vaporization, so that HF + H₂O can cause etching of the film containing Si and O (SiO₂ film).

The first etching method preferably includes simultaneously bringing the (I) HF gas and the (II) compound into contact with the substrate in the chamber and subjecting the interior of the chamber to a reduced pressure condition, and these steps may be repeated to perform etching. The step of subjecting the interior of the chamber to a reduced pressure condition may be replaced by purging the interior of the chamber with inert gas. Alternatively, the step of subjecting the interior of the chamber to a reduced pressure condition may be followed by purging the interior of the chamber with inert gas. In an embodiment of the first etching method, the step of simultaneously bringing the (I) HF gas and the (II) compound into contact with the substrate in the chamber is preferably followed by subjecting the interior of the chamber to a reduced pressure condition and/or by purging the interior of the chamber with inert gas.

### [Second etching method]

Next, a second etching method that includes a first etching step including bringing the (I) HF gas into contact with the substrate and a second etching step including bringing the (II) compound into contact with the substrate is described as an embodiment of the etching method of the present disclosure. Hereinafter, the etching gas used in the first etching step in the second etching method is referred to as etching gas B, while the etching gas used in the second etching step is referred to as etching gas C. The etching gas B at least contains the (I) HF gas, while the etching gas C at least contains the (II) compound.

When the heated film to be etched is subjected to the second etching step, specifically, when the etching gas C containing the (II) compound is brought into contact with the film to be etched, the (II) compound can directly bind to Si-NH₂ on the surface of the film containing Si and N (particularly, SiN film) without proton (H⁺) release. Then, when the films are brought into contact with the etching gas B containing the (I) HF gas in the first etching step, it is considered that the film containing Si and N can be selectively etched without NH₃ generation.

In the second etching method of the present disclosure, the above steps may be repeated multiple times to repeatedly etch the film to be etched. One etching cycle can etch a certain thickness, and therefore a desired thickness of the layer can be precisely etched by specifying the number of cycles.

The (II) compound may be as described above.

Although the etching gas B may consist only of the (I) HF gas and the etching gas C may consist only of the (II) compound, the etching gas B and the etching gas C may each further contain at least one additive gas selected from the group consisting of O₂, NO, N₂O, CO, CO₂, H₂O₂, and alcohols. The etching gas B and the etching gas C may each further contain at least one inert gas selected from the group consisting of N₂, Ar, He, Ne, and Kr. Moreover, examples of usable alcohols include methanol, ethanol, propanol, and isopropyl alcohol.

When the etching gas B contains the additive gas, the total amount of additive gas in the etching gas B may be 10 vol% or more and 90 vol% or less based on the combined amount of (I) HF gas, additive gas, and inert gas taken as 100 vol%.

Moreover, when the etching gas C contains the additive gas, the total amount of additive gas in the etching gas C may be 10 vol% or more and 90 vol% or less based on the combined amount of (II) compound, additive gas, and inert gas taken as 100 vol%.

When the etching gas B contains the inert gas, the amount of inert gas in the etching gas B is preferably 1 vol% or more and 90 vol% or less, more preferably 10 vol% or more and 80 vol% or less, still more preferably 30 vol% or more and 50 vol% or less based on the combined amount of (I) HF gas, additive gas, and inert gas taken as 100 vol%.

When the etching gas C contains the inert gas, the amount of inert gas in the etching gas C is preferably 1 vol% or more and 90 vol% or less, more preferably 10 vol% or more and 80 vol% or less, still more preferably 30 vol% or more and 50 vol% or less based on the combined amount of (II) compound, additive gas, and inert gas taken as 100 vol%.

The moisture content of the etching gas B and the moisture content of the etching gas C are each preferably less than 1% by mass, because with a high moisture content, H₂O can be generated upon vaporization, so that HF + H₂O can cause etching of the film containing Si and O (SiO₂ film).

The second etching method preferably includes performing the first etching step and the second etching step in the chamber and further includes subjecting the interior of the chamber to a reduced pressure condition. These steps are preferably repeated to perform etching. The step of subjecting the interior of the chamber to a reduced pressure condition may be replaced by purging the interior of the chamber with inert gas. Alternatively, the step of subjecting the interior of the chamber to a reduced pressure condition may be followed by purging the interior of the chamber with inert gas. In an embodiment of the second etching method, preferably, the second etching step is followed by subjecting the interior of the chamber to a reduced pressure condition and/or by purging the interior of the chamber with inert gas, and subsequently the first etching step is performed, followed by subjecting the interior of the chamber to a reduced pressure condition and/or by purging the interior of the chamber with inert gas.

Another embodiment of the present disclosure is an etching method that includes bringing (I) HF gas and (II) at least one compound selected from the group consisting of a sulfonyl compound represented by formula [1], a carbonyl compound represented by formula [2], a sulfonyl isocyanate compound represented by formula [3], and an isocyanate compound represented by formula [4] into contact with a substrate having a polycrystalline silicon film and a film at least containing Si and N to etch the film at least containing Si and N.

In addition to the polycrystalline silicon film and the film at least containing Si and N, a film at least containing Si and O, a film containing a metal nitride, a silicon film, a metal wiring film, or other film may be formed on the surface of the substrate.

The (II) compound to be brought into contact with the substrate and the etching conditions may be as described for the etching method performed on the substrate having a film at least containing Si and O and a film at least containing Si and N described above.

### [Etching device]

The etching method of the present disclosure can be accomplished, for example, using the etching device described below. Such an etching device is another embodiment of the present disclosure.

The etching device of the present disclosure includes: a stage on which a substrate can be placed; a HF gas supply unit for supplying (I) HF gas; and a gaseous compound (II) supply unit for supplying gas of (II) at least one compound (hereinafter, also referred to as "gaseous compound (II)") selected from the group consisting of a sulfonyl compound represented by formula [1], a carbonyl compound represented by formula [2], a sulfonyl isocyanate compound represented by formula [3], and an isocyanate compound represented by formula [4]. The etching device of the present disclosure may further include an inert gas supply unit for supplying inert gas into the chamber.

FIG. 1 shows a schematic diagram of an etching device according to an embodiment of the present disclosure.

An etching device 100 shown in FIG. 1 includes a chamber 110 in which a substrate 113 can be placed, a HF gas supply unit 140 that is connected to the chamber 110 to supply HF gas, a gaseous compound (II) supply unit 150 for supplying a gaseous compound (II), an inert gas supply unit 130 for supplying inert gas, and a heating means 111 for heating the chamber 110. It should be noted that the etching device 100 may not include the inert gas supply unit 130.

The etching device 100 further includes a control unit that is not shown in the figure. For example, the control unit constitutes a computer and includes a program, a memory, and a CPU. The program incorporates a group of steps to implement a series of operations in the first etching method or the second etching method. In accordance with the program, operations may be performed such as adjusting the temperature of the substrate 113, opening or closing the valves of the supply units, adjusting the flow rates of the gases, and adjusting the pressure in the chamber 110. This program is stored on a computer storage medium, such as a compact disk, a hard disk, a magnetooptical disk, or a memory card, and installed in the control unit.

The chamber 110 is provided with a stage 112 for placing the substrate 113 thereon. The chamber 110 is not particularly limited as long as it is resistant to the HF gas used and depressurizable to a predetermined pressure. Usually, a general chamber or the like included in a semiconductor etching device may be used. The supply pipes for supplying the etching gases and other pipes are also not particularly limited as long as they are resistant to HF gas, and any general pipes can be used.

The HF gas supply unit 140 can control the amount of supply using valves 143 and 144 and a flow rate controlling means 142 to supply the HF gas through pipes 141 and 145 to a pipe 121.

The gaseous compound (II) supply unit 150 can control the amount of supply using valves 153 and 154 and a flow rate controlling means 152 to supply the gaseous compound (II) through pipes 151 and 155 to the pipe 121.

The inert gas supply unit 130 can control the amount of supply using valves 133 and 134 and a flow rate controlling means 132 to supply the inert gas through pipes 131 and 135 to the pipe 121.

The heating means 111 for heating the chamber 110 is disposed outside the chamber 110. A heater (not shown) may also be provided as a second heating means inside the stage 112. Here, when a plurality of stages are provided in the chamber 110, each stage may be provided with a heater so that the temperature of the substrate on each stage can be individually set to a predetermined temperature.

A gas discharge means for discharging reacted gas is disposed on one side of the chamber 110. The reacted gas can be discharged from the chamber 110 through a pipe 122 by a vacuum pump 127 of the gas discharge means. The reacted gas can be collected by a liquid nitrogen trap (not shown) disposed between the pipe 122 and the vacuum pump 127. Valves 125 and 126 may be disposed in the pipes 121 and 122, respectively, to control the pressure. Moreover, in FIG. 1, the reference signs PI (123 and 124) each represent a pressure gauge. According to its readings, the control unit can control each flow rate controlling means and each valve.

The etching method is specifically described using the etching device 100 as an example.

### [First etching method using the above etching device]

The first etching method of the present disclosure includes bringing the etching gas A containing the HF gas and the (II) compound into contact with the film to be etched.

In the first etching method, first, the substrate 113 provided with the film to be etched, including a film at least containing Si and O and a film at least containing Si and N, is placed in the chamber 110. Next, the interiors of the chamber 110, the pipes 121 and 122, the pipes 131 and 135, the pipes 141 and 145, and the pipes 151 and 155 are each subjected to vacuum evacuation to a predetermined pressure using the vacuum pump 127, and then the substrate 113 is heated with the heating means 111.

When the temperature of the substrate 113 reaches a predetermined temperature, the HF gas and the gaseous compound (II) are supplied at respective predetermined flow rates from the HF gas supply unit 140 and the gaseous compound (II) supply unit 150, respectively, to the pipe 121. Here, the inert gas may be supplied at a predetermined flow rate from the inert gas supply unit 130 to the pipe 121.

The HF gas and the gaseous compound (II) are mixed at a predetermined compositional ratio and supplied to the chamber 110. The pressure in the chamber 110 is controlled to a predetermined pressure while introducing the mixed etching gas into the chamber 110. The etching gas A and the film to be etched are reacted with each other for a predetermined period of time to perform etching. This etching method enables plasmaless etching without plasma and eliminates the need to excite the etching gas A using plasma or the like during the etching. The flow rate of the etching gas A may be appropriately set according to the volume, pressure, and other conditions of the chamber.

It should be noted that etching associated with plasma means that gas or the like at about 0.01 to 1.33 kPa, for example, is introduced into a reactor, and a highfrequency power is applied to an outer coil or a counter electrode to generate low-temperature gas plasma in the reactor, thereby performing etching with the active chemical species such as ions or radicals formed in the plasma.

The etching method of the present disclosure provides contact with gas without plasma to perform dry etching without generating the gas plasma described above.

After completion of the etching step, the heating with the heating means 111 is stopped to lower the temperature. At the same time, the vacuum pump 127 is also stopped, followed by purging with inert gas to release the vacuum. As described above, the first etching method using the etching device described above can selectively etch the film containing Si and N in the film to be etched.

### (Etching conditions in first etching method)

In the first etching method of the present disclosure, the temperature of the film to be etched, when brought into contact with the etching gas A, may be any temperature at which the etching gas A can react with the film containing Si and N (SiN film). In particular, the temperature of the film to be etched, which is to be removed, is preferably 20°C or higher and 200°C or lower, more preferable 30°C or higher and 150°C or lower, still more preferably 40°C or higher and 130°C or lower.

Moreover, when the etching gas A is brought into contact with the film to be etched, the pressure in the chamber in which the substrate provided with the film to be etched is placed is not particularly limited, but it is usually within a pressure range of 0.01 kPa or higher and 101.3 kPa or lower.

To obtain a sufficient etching rate, the pressure in the chamber during the etching step is preferably 0.01 kPa or higher and 101.3 kPa or lower, more preferably 0.1 kPa or higher and 50 kPa or lower, still more preferably 1 kPa or higher and 20 kPa or lower.

The processing time in the etching step is not particularly limited, but it is preferably within 60 minutes, in view of the efficiency of the semiconductor device production process. Here, the processing time in the etching step refers to the time from when the etching gas A is introduced into the chamber in which the substrate has been placed to when the etching gas A in the chamber is then discharged by the vacuum pump or the like to terminate the etching process.

### [Second etching method using the above etching device]

The second etching method of the present disclosure includes a first etching step including bringing the etching gas B containing the HF gas into contact with the film to be etched and a second etching step including bringing the etching gas C containing the (II) compound into contact with the film to be etched.

In the second etching method, first, the substrate 113 provided with a film at least containing Si and O and a film at least containing Si and N is placed in the chamber 110. Next, the interiors of the chamber 110, the pipes 121 and 122, the pipes 131 and 135, the pipes 141 and 145, and the pipes 151 and 155 are each subjected to vacuum evacuation to a predetermined pressure using the vacuum pump 127, and then the substrate 113 is heated with the heating means 111.

When the temperature of the substrate 113 reaches a predetermined temperature, first, the gaseous compound (II) is supplied at a predetermined flow rate from the gaseous compound (II) supply unit 150 to the pipe 121. Here, the inert gas may be supplied at a predetermined flow rate from the inert gas supply unit 130 to the pipe 121. The pressure in the chamber 110 is controlled to be a predetermined pressure while introducing the gaseous compound (II) or the gaseous compound (II) and the inert gas into the chamber 110. The gaseous compound (II) is introduced into the chamber 110 for a predetermined period of time so that the gaseous compound (II) can adsorb onto the film to be etched.

After vacuum evacuation of the gas containing the gaseous compound (II), the HF gas is supplied at a predetermined flow rate from the HF gas supply unit 140 to the pipe 121. Here, the inert gas may be supplied at a predetermined flow rate from the inert gas supply unit 130 to the pipe 121. The pressure in the chamber 110 is controlled to be a predetermined pressure while introducing the HF gas or the HF gas and the inert gas into the chamber 110. The HF gas is introduced into the chamber 110 for a predetermined period of time so that the film containing Si and N in the film to be etched can be selectively etched.

The second etching method of the present disclosure may include repeated cycles, each of which includes the first etching step including introducing the HF gas into the chamber 110 and the second etching step including introducing the gaseous compound (II) into the chamber 110.

In the second etching method of the present disclosure, the etching conditions in one cycle may be set to predetermined conditions to control the thickness of the film to be etched that can be etched in one cycle. Thus, the thickness of the film to be etched that can be etched in one cycle may be set to be small to precisely control the etching thickness.

In the second etching method of the present disclosure, preferably, the second etching step is followed by subjecting the interior of the chamber to a reduced pressure condition, and subsequently the first etching step is performed. Also preferably, every cycle includes subjecting the interior of the chamber to a reduced pressure condition.

It should be noted that the second etching method also enables plasmaless etching without plasma and eliminates the need to excite the etching gas using plasma or the like during the etching. The flow rates of the HF gas and the gaseous compound (II) may be appropriately set according to the volume, pressure, and other conditions of the chamber.

As described above, the second etching method of the present disclosure using the etching device described above can provide contact with gas without plasma to perform dry etching without generating the gas plasma described above.

After completion of the etching step, the heating with the heating means 111 is stopped to lower the temperature. At the same time, the vacuum pump 127 is stopped, followed by purging with inert gas to release the vacuum. The second etching method using the etching device described above can selectively etch the film containing Si and N in the film to be etched.

### (Etching conditions in second etching method)

In the second etching method of the present disclosure, the temperature of the film to be etched during the etching step may be any temperature at which the etching gas B can react with the film containing Si and N (SiN film), and the etching gas C can also react with the film containing Si and N (SiN film). In particular, the temperature of the film to be etched, which is to be removed, is preferably 20°C or higher and 200°C or lower, more preferable 30°C or higher and 150°C or lower, still more preferably 40°C or higher and 130°C or lower. The temperature of the film to be etched in the first etching step is desirably the same as that in the second etching step.

Moreover, the pressure in the chamber in the etching step is not particularly limited, but it is usually within a pressure range of 0.01 kPa or higher and 101.3 kPa or lower.

To obtain a sufficient etching rate, the pressure in the chamber in the first etching step and the second etching step is preferably 0.01 kPa or higher and 101.3 kPa or lower, more preferably 0.1 kPa or higher and 50 kPa or lower, still more preferably 1 kPa or higher and 20 kPa or lower. The pressure in the chamber in the second etching step is desirably higher than the pressure in the chamber in the first etching step.

The processing time in the first etching step and the second etching step is not particularly limited, but the processing time in one cycle of the first etching step is preferably within 60 minutes, and the processing time in one cycle of the second etching step is preferably within 60 minutes. Here, the processing time in each etching step refers to the time from when the etching gas is introduced into the chamber in which the substrate has been placed to when the etching gas in the chamber is then discharged by the vacuum pump or the like to terminate the etching process.

### [Method of producing semiconductor device]

The etching method of the present disclosure described above can be used as a method of applying the etching method to a substrate having a silicon nitride film and a silicon oxide film to selectively etch the silicon nitride film. When the silicon nitride film on the substrate is selectively etched by the etching method of the present disclosure, a semiconductor device can be produced at a low cost.

The method of producing a semiconductor device according to the present disclosure includes applying the etching method described above to a substrate having a silicon nitride film and a silicon oxide film to selectively etch the silicon nitride film. The etching method of the present disclosure described above can be used to react the substrate having a silicon nitride film and a silicon oxide film with the HF gas and the (II) compound to selectively etch the silicon nitride film without plasma. The substrate may further have a polycrystalline silicon film. The substrate is preferably a silicon substrate.

### [Etching gas]

Another embodiment of the present disclosure is an etching gas containing (I) HF gas and (II) at least one compound selected from the group consisting of a sulfonyl compound represented by formula [1], a carbonyl compound represented by formula [2], a sulfonyl isocyanate compound represented by formula [3], and an isocyanate compound represented by formula [4]. Embodiments of the etching gas of the present disclosure may be as described for the etching gas A described above. Specifically, the etching gas of the present disclosure is a mixture at least containing the (I) HF gas and the (II) compound.

### EXAMPLES

The present disclosure is described in detail below with reference to examples. The present disclosure is not limited to the examples.

First, a silicon wafer provided with a SiN film, a silicon wafer provided with a SiO₂ film, and a silicon wafer provided with a polycrystalline silicon (p-Si) film were prepared as substrates to be processed. The film thickness of each substrate to be processed was measured with a spectroscopic ellipsometer (product name: SE-2000, Semilabo Japan KK) before and after the etching process to determine the etching amount, the selection ratio of SiN to SiO₂, and the selection ratio of SiN to p-Si (SiN/SiO₂ selection ratio and SiN/p-Si selection ratio).

### [Example 1]

An etching device 100 as shown in FIG. 1 was used. First, the substrates to be processed were placed on a stage in a chamber. After sufficiently vacuuming the chamber, the temperature of the stage was adjusted to 120°C. The temperature of each substrate is the same as the temperature of the stage and is substantially equal to the temperature of the film to be etched. Next, N₂ gas was allowed to flow into the chamber to sufficiently dry the interior. Subsequently, HF gas and CF₃S(=O)₂F (trifluoromethanesulfonyl fluoride) gas were allowed to flow into the chamber for one minute. At this time, the flow rates of HF gas and CF₃S(=O)₂F gas were 200 sccm and 100 sccm, respectively, and the pressure in the chamber was 6.66 kPa. Lastly, after vacuuming the chamber and purging with N₂ gas, the substrates to be processed were taken out. Table 1 shows the results. The silicon wafer provided with a SiN film, the silicon wafer provided with a SiO₂ film, and the silicon wafer provided with a polycrystalline silicon (p-Si) film as the substrates to be processed were all placed in the same chamber and simultaneously subjected to the etching process.

### [Example 2]

A test was performed under the same conditions as in Example 1, except that HF gas and CF₃C(=O)CF₃ (hexafluoroacetone) gas instead of the HF gas and CF₃S(=O)₂F gas were allowed to flow for 15 minutes. Table 1 shows the results.

### [Example 3]

A test was performed under the same conditions as in Example 1, except that HF gas and FS(=O)₂N=C=O (fluorosulfonyl isocyanate) gas instead of the HF gas and CF₃S(=O)₂F gas were allowed to flow for 15 minutes. Table 1 shows the results.

### [Example 4]

A test was performed under the same conditions as in Example 1, except that HF gas and S(=O)₂F₂ (sulfuryl fluoride) gas instead of the HF gas and CF₃S(=O)₂F gas were allowed to flow for 15 minutes. Table 1 shows the results.

### [Comparative Example 1]

A test was performed under the same conditions as in Example 1, except that HF gas and N₂ gas instead of the HF gas and CF₃S(=O)₂F gas were allowed to flow for 10 minutes. Table 1 shows the results.

### [Example 5]

First, the substrates to be processed were placed on a stage in a chamber. After sufficiently vacuuming the chamber, the temperature of the stage was adjusted to 120°C. Next, N₂ gas was allowed to flow into the chamber to sufficiently dry the interior.
(A) Subsequently, CF₃S(=O)₂F gas was allowed to flow into the chamber, followed by sufficient vacuuming and purging with N₂ gas. At this time, the flow rate of CF₃S(=O)₂F gas was 100 sccm, the pressure was 6.66 kPa, and the CF₃S(=O)₂F gas flowing time was two minutes.
(B) Next, HF gas was allowed to flow into the chamber while being diluted with N₂ gas, followed by sufficient vacuuming and purging with N₂ gas. At this time, the flow rates of HF gas and N₂ gas were 200 sccm and 100 sccm, respectively, the pressure was 6.66 kPa, and the HF gas/N₂ gas flowing time was one minute.

Here, cycle etching was performed by repeating the above steps (A) and (B) 10 times. Lastly, the substrates to be processed were taken out from the interior of the chamber. Table 2 shows the results. Here, the etching rate was determined based on the HF gas/N₂ gas flowing time.

### [Example 6]

A test was performed under the same conditions as in Example 1, except that the pressure in the chamber was 5.33 kPa, and the HF gas and CF₃S(=O)₂F gas were allowed to flow for three minutes. Table 3 shows the results.

### [Example 7]

A test was performed under the same conditions as in Example 1, except that the temperature of the stage was 50°C, and the HF gas and CF₃S(=O)₂F gas were allowed to flow for three minutes. Table 3 shows the results.

### [Example 8]

A test was performed under the same conditions as in Example 7, except that the HF gas and CF₃S(=O)₂F gas were allowed to flow into the chamber having an interior pressure of 4.00 kPa. Table 3 shows the results.

### [Example 9]

A test was performed under the same conditions as in Example 7, except that the HF gas and CF₃S(=O)₂F gas were allowed to flow into the chamber having an interior pressure of 2.00 kPa. Table 3 shows the results.

### [Example 10]

A test was performed under the same conditions as in Example 1, except that the temperature of the stage was 30°C, and the HF gas and CF₃S(=O)₂F gas were allowed to flow for three minutes. Table 3 shows the results.

### [Example 11]

A test was performed under the same conditions as in Example 10, except that the HF gas and CF₃S(=O)₂F gas were allowed to flow into the chamber having an interior pressure of 4.00 kPa. Table 3 shows the results.

### [Example 12]

A test was performed under the same conditions as in Example 10, except that the HF gas and CF₃S(=O)₂F gas were allowed to flow into the chamber having an interior pressure of 2.00 kPa. Table 3 shows the results.

### [Comparative Example 2]

A test was performed under the same conditions as in Example 6, except that the pressure in the chamber was 13.33 kPa, and HF gas and N₂ gas instead of the HF gas and CF₃S(=O)₂F gas were allowed to flow for 30 minutes. Table 3 shows the results.

### [Comparative Example 3]

A test was performed under the same conditions as in Example 6, except that the pressure in the chamber was 4.00 kPa, and HF gas and N₂ gas instead of the HF gas and CF₃S(=O)₂F gas were allowed to flow for 30 minutes. Table 3 shows the results.

**[Table 1]**

| | Processing pressure [kPa] | Processing temperature [°C] | HF gas flow rate [sccm] | Gaseous compound (II) | Gaseous compound (II) flow rate [sccm] | Additive gas | Additive gas flow rate [sccm] | Time [min] | SiN etching rate [nm/min] | SiO₂ etching rate [nm/min] | SiN/SiO₂ selection ratio | p-Si etching rate [nm/min] | SiN/p-Si selection ratio |
|---|---|---|---|---|---|---|---|---|---|---|---|---|---|
| Example 1 | 6.66 | 120 | 200 | CF₃S(=O)₂F | 100 | - | - | 1 | 2.2 | 0.0 | ∞ | 0.0 | ∞ |
| Example 2 | 6.66 | 120 | 200 | CF₃C(=O)CF₃ | 100 | - | - | 15 | 3.6 | 0.1 | 36 | 0.0 | ∞ |
| Example 3 | 6.66 | 120 | 200 | FS(=O)₂N=C=O | 100 | - | - | 15 | 0.8 | 0.0 | ∞ | 0.0 | ∞ |
| Example 4 | 6.66 | 120 | 200 | S(=O)₂F₂ | 100 | - | - | 15 | 3.6 | 0.2 | 18 | 0.0 | ∞ |
| Comparative Example 1 | 6.66 | 120 | 200 | - | - | N₂ | 100 | 10 | 3.5 | 1.8 | 1.9 | 0.0 | ∞ |

**[Table 2]**

| | Processing pressure [kPa] | Processing temperature [°C] | Gas flow (A) | | Gas flow (B) | | | SiN etching rate [nm/min] | SiO₂ etching rate [nm/min] | SiN/SiO₂ selection ratio | p-Si etching rate [nm/min] | SiN/p-Si selection ratio |
|---|---|---|---|---|---|---|---|---|---|---|---|---|
| | | | Gaseous compound (II) | Gaseous compound (II) flow rate [sccm] | HF gas flow rate [sccm] | Additive gas | Additive gas flow rate [sccm] | | | | | |
| Example 5 | 6.66 | 120 | CF₃S(=O)₂F | 100 | 200 | N₂ | 100 | 5.5 | 0.0 | ∞ | 0.0 | ∞ |

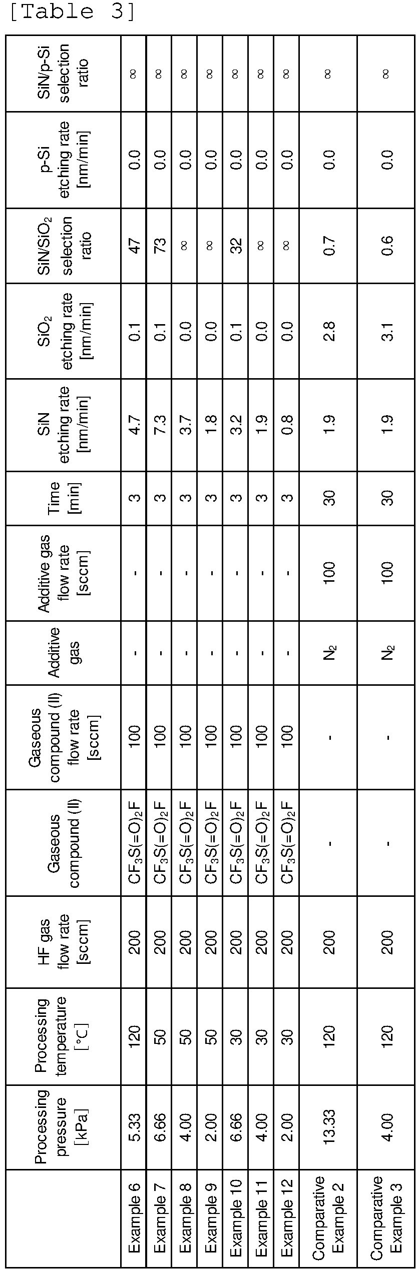

Table 1 shows the gas flow conditions and the results of the etching rates of the substrates to be processed, SiN/SiO₂ selection ratio, and SiN/p-Si selection ratio in Examples 1 to 4 and Comparative Example 1. Table 2 shows the gas flow conditions and the results of the etching rates of the substrates to be processed, SiN/SiO₂ selection ratio, and SiN/p-Si selection ratio in Example 5. Table 3 shows the gas flow conditions and the results of the etching rates of the substrates to be processed, SiN/SiO₂ selection ratio, and SiN/p-Si selection ratio in Examples 6 to 12 and Comparative Examples 2 and 3.

The etching rates of the SiO₂ film in Examples 1 to 12 were 0.0 to 0.2 nm, while the etching rates in Comparative Examples 1 to 3 were 1.0 nm or more, demonstrating that the etching of the SiO₂ film was suppressed in Examples 1 to 12.

The SiN/SiO₂ selection ratio was ∞ in Examples 1, 3, 5, 8, 9, 11, and 12, 36 in Example 2, 18 in Example 4, 47 in Example 6, 73 in Example 7, and 32 in Example 10.

Moreover, the SiN/p-Si selection ratio was ∞ in Examples 1 to 12. Comparative Example 1 had the results where the SiO₂ surface was scraped although the SiN/p-Si selection ratio was ∞ and the SiN/SiO₂ selection ratio was 1.9.

The above results of Examples 1 to 12 revealed that flowing HF gas and (II) compound such as CF₃S(=O)₂F gas enables the etching of SiN while suppressing the etching of SiO₂ or p-Si.

### REFERENCE SIGNS LIST

100 etching device
110 chamber
111 heating means
112 stage
113 substrate
121, 122 pipe
123, 124 PI (pressure gauge)
125, 126 valve
127 vacuum pump
130 inert gas supply unit
131, 135 pipe
132 flow rate controlling means
133, 134 valve
140 HF gas supply unit
141, 145 pipe
142 flow rate controlling means
143, 144 valve
150 gaseous compound (II) supply unit
151, 155 pipe
152 flow rate controlling means
153, 154 valve

## Claims

1. An etching method, comprising bringing (I) HF gas and (II) at least one compound selected from the group consisting of a sulfonyl compound represented by the following formula [1], a carbonyl compound represented by the following formula [2], a sulfonyl isocyanate compound represented by the following formula [3], and an isocyanate compound represented by the following formula [4] into contact with a substrate having a film at least containing Si and O and a film at least containing Si and N to etch the film at least containing Si and N,
R¹-S(=O)₂-X [1]
wherein R¹ represents a halogen atom or a linear or branched C1-C6 alkyl group in which some or all hydrogen atoms are optionally replaced by fluorine atoms, and X represents a halogen atom;
R²-C(=O)-R³ [2]
wherein R² and R³ each independently represent a hydrogen atom, a halogen atom, an isocyanate group, or a linear or branched C1-C6 alkyl group in which some or all hydrogen atoms are optionally replaced by fluorine atoms;
R⁴-S(=O)₂N=C=O [3]
wherein R⁴ represents a halogen atom or a linear or branched C1-C6 alkyl group in which some or all hydrogen atoms are optionally replaced by fluorine atoms; and
R⁵-N=C=O [4]
wherein R⁵ represents a linear or branched C1-C10 alkyl group in which some or all hydrogen atoms are optionally replaced by fluorine atoms.

2. The etching method according to claim 1,
wherein the film at least containing Si and N is etched without plasma.

3. The etching method according to claim 1,
wherein the film at least containing Si and N is selectively etched.

4. The etching method according to claim 1,
wherein the film at least containing Si and N is selectively etched, and
the film at least containing Si and O is etched at a rate of 1.0 nm/min or less.

5. The etching method according to claim 1,
wherein R¹ in formula [1] represents a fluoroalkyl group or a fluorine atom, and X represents a fluorine atom.

6. The etching method according to claim 1,
wherein the sulfonyl compound represented by formula [1] is trifluoromethanesulfonyl fluoride (CF₃S(=O)₂F) or sulfuryl fluoride (SO₂F₂).

7. The etching method according to claim 1,
wherein the carbonyl compound represented by formula [2] is hexafluoroacetone (CF₃C(=O)CF₃), trifluoroacetaldehyde (CF₃C(=O)H), or fluorocarbonyl isocyanate (FC(=O)N=C=O).

8. The etching method according to claim 1,
wherein the isocyanate compound represented by formula [3] is fluorosulfonyl isocyanate (FS(=O)₂N=C=O).

9. The etching method according to claim 1,
wherein the etching is performed with the substrate placed in a chamber, and
the method comprises subjecting an interior of the chamber to a reduced pressure condition.

10. The etching method according to claim 1,
wherein the (I) HF gas and the (II) compound are simultaneously brought into contact with the substrate.

11. The etching method according to claim 1,
wherein the method comprises:
a first etching step including bringing the (I) HF gas into contact with the substrate; and
a second etching step including bringing the (II) compound into contact with the substrate.

12. The etching method according to claim 11,
wherein the etching is performed by repeating the first etching step and the second etching step.

13. The etching method according to claim 11,
wherein the second etching step is followed by the first etching step.

14. The etching method according to claim 1,
wherein the film at least containing Si and O is a silicon oxide (SiO₂) film.

15. The etching method according to claim 1,
wherein the film at least containing Si and N is a silicon nitride (SiN) film.

16. The etching method according to claim 1,
wherein, in the substrate, the film at least containing Si and O and the film at least containing Si and N are a silicon oxide (SiO₂) film and a silicon nitride (SiN) film, respectively, and the silicon oxide film and the silicon nitride film are adjacent to each other and exposed.

17. A method of producing a semiconductor device, the method comprising applying the etching method according to any one of claims 1 to 15 to a substrate having a silicon nitride film and a silicon oxide film to selectively etch the silicon nitride film.

18. An etching device, comprising:
a stage on which a substrate can be placed;
a HF gas supply unit for supplying (I) HF gas; and
a gaseous compound (II) supply unit for supplying gas of (II) at least one compound selected from the group consisting of a sulfonyl compound represented by the following formula [1], a carbonyl compound represented by the following formula [2], a sulfonyl isocyanate compound represented by the following formula [3], and an isocyanate compound represented by the following formula [4],
R¹-S(=O)₂-X [1]
wherein R¹ represents a halogen atom or a linear or branched C1-C6 alkyl group in which some or all hydrogen atoms are optionally replaced by fluorine atoms, and X represents a halogen atom;
R²-C(=O)-R³ [2]
wherein R² and R³ each independently represent a hydrogen atom, a halogen atom, an isocyanate group, or a linear or branched C1-C6 alkyl group in which some or all hydrogen atoms are optionally replaced by fluorine atoms;
R⁴-S(=O)₂N=C=O [3]
wherein R⁴ represents a halogen atom or a linear or branched C1-C6 alkyl group in which some or all hydrogen atoms are optionally replaced by fluorine atoms; and
R⁵-N=C=O [4]
wherein R⁵ represents a linear or branched C1-C10 alkyl group in which some or all hydrogen atoms are optionally replaced by fluorine atoms.

19. An etching gas, comprising:
(I) HF gas; and
(II) at least one compound selected from the group consisting of a sulfonyl compound represented by the following formula [1], a carbonyl compound represented by the following formula [2], a sulfonyl isocyanate compound represented by the following formula [3], and an isocyanate compound represented by the following formula [4],
R¹-S(=O)₂-X [1]
wherein R¹ represents a halogen atom or a linear or branched C1-C6 alkyl group in which some or all hydrogen atoms are optionally replaced by fluorine atoms, and X represents a halogen atom;
R²-C(=O)-R³ [2]
wherein R² and R³ each independently represent a hydrogen atom, a halogen atom, an isocyanate group, or a linear or branched C1-C6 alkyl group in which some or all hydrogen atoms are optionally replaced by fluorine atoms;
R⁴-S(=O)₂N=C=O [3]
wherein R⁴ represents a halogen atom or a linear or branched C1-C6 alkyl group in which some or all hydrogen atoms are optionally replaced by fluorine atoms; and
R⁵-N=C=O [4]
wherein R⁵ represents a linear or branched C1-C10 alkyl group in which some or all hydrogen atoms are optionally replaced by fluorine atoms.
